# EUROPÄISCHE PATENTSCHRIFT

(11) **EP 0 560 107 B1**
(45) Veröffentlichungstag und Bekanntmachung des Hinweises auf die Patenterteilung: **18.10.1995**
(21) Anmeldenummer: 93102751.0
(22) Anmeldetag: 22.02.1993
(51) Int. Cl.: G02B 5/00, F21S 11/00, F24J 2/06, H01L 31/00

(54) **Vorrichtung zur Konzentration oder zur Umlenkung von Licht**
Device for concentrating or deflecting light
Dispositif pour concentrer ou dévier la lumière

(30) Priorität: 13.03.1992 DE 4208006
(43) Veröffentlichungstag der Anmeldung: 15.09.1993
(73) Patentinhaber: Feustle, Gerhard, D-86156 Augsburg (DE)
(72) Erfinder: Feustle, Gerhard, D-86156 Augsburg (DE)
(74) Vertreter: Charrier, Rolf, Dipl.-Ing.

(56) Entgegenhaltungen:
- DE-A- 103 721
- FR-A- 777 208
- US-A- 2 844 998
- US-A- 4 657 355

## Beschreibung

Die Erfindung betrifft eine Vorrichtung zur Konzentration oder zur Verteilung von Licht nach dem Oberbegriff des Anspruchs 1.

Aus der DE-B-103 721 ist eine gattungsgemäße Vorrichtung bekannt, welche eine erste, flächige Prismenanordnung aus vielen, im wesentlichen prismatischen Profilen und eine zweite, gleichartige Prismenanordnung aufweist, wobei die zweite Prismenanordnung in konstantem Abstand gegenüber der ersten Prismenanordnung angeordnet ist. Jedem Profil der ersten Prismenanordnung ist ein Profil der zweiten Prismenanordnung zugeordnet, wodurch bewirkt wird, daß jeder die Vorrichtung durchlaufende Lichtstrahl an mindestens zwei Grenzflächen der beiden Prismenanordnungen in gleichem Drehsinn gebrochen wird. Ähnliche Vorrichtungen werden auch in der US-A-2,844,998 und der FR-B-777 208 beschrieben.

Die genannten Vorrichtungen weisen den Nachteil auf, daß sie sich beispielsweise für die gleichförmige Hintergrundbeleuchtung einer Flüssigkristallanzeige schlecht eignen, da die Lichtintensität mit zunehmenden Abstand von der Lichtquelle abnimmt. Auch bei anderen Verwendungsformen, unter anderem als Lichtkonzentrator vor Solarelementen, weisen die bekannten Vorrichtungen ähnliche Nachteile auf.

Es besteht daher die Aufgabe, die Vorrichtung so weiterzubilden, daß insbesondere in ihrer Verwendung als Lichtverteiler hinter einer Flüssigkristallanzeige eine gleichmäßigere Ausleuchtung gewährleistet ist.

Gelöst wird diese Aufgabe mit den kennzeichnenden Merkmalen des Anspruchs 1. Vorteilhafte Ausgestaltungen sind den Unteransprüchen entnehmbar.

Einige Ausführungsbeispiele der Erfindung werden im folgenden unter Bezugnahme auf die Zeichnungen näher erläutert. Darin bezeichnen gleiche Bezugszahlen einander entsprechende Bauteile bzw. Orte. Es zeigen:
**Fig. 1** einen Querschnitt durch eine erfindungsgemäße Vorrichtung in Verbindung mit einem Solarelement;
**Fig. 2** einen Ausschnitt aus einem Querschnitt durch eine andere Ausführungsform einer erfindungsgemäßen Vorrichtung;
**Fig. 3a** einen Querschnitt durch eine andere Ausführungsform der erfindungsgemäßen Vorrichtung;
**Fig. 3b** einen Spiegel zur Verwendung in der Ausführungsform nach Figur 3a;
**Fig. 4a** eine Draufsicht auf eine erfindungsgemäße Vorrichtung;
**Fig. 4b** einen Längsschnitt durch die Vorrichtung nach Figur 4a;
**Fig. 4c** einen Querschnitt durch die Vorrichtung nach Figur 4a;
**Fig. 5a, b, c, d** Ausschnitte aus Querschnitten von alternativen Ausführungsformen der vorliegenden Erfindung.

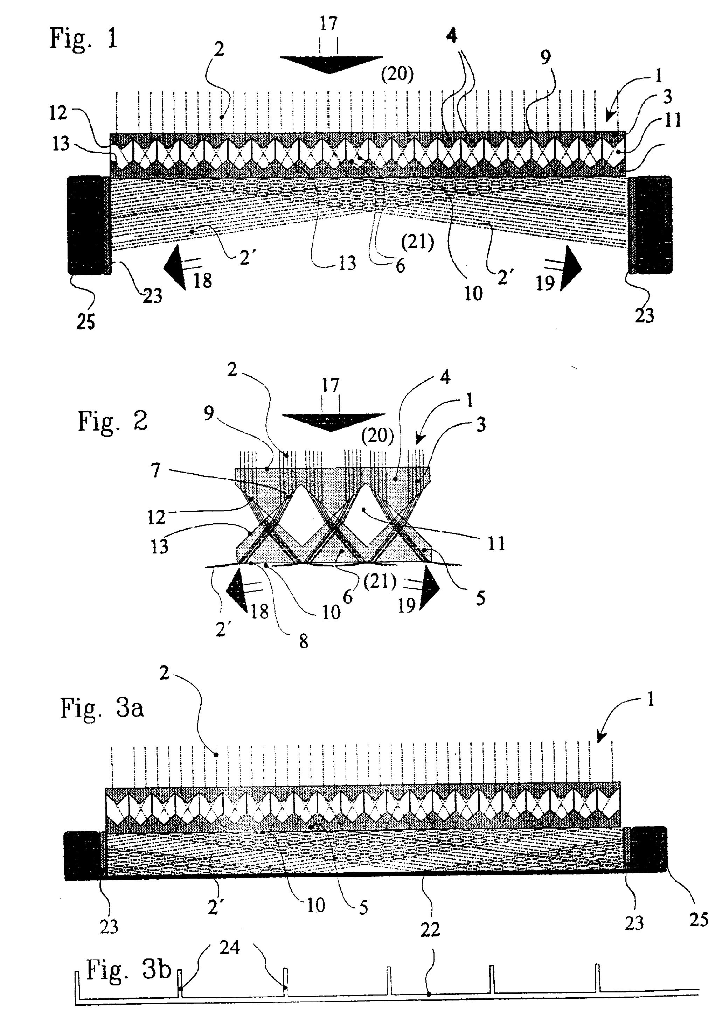

Figur 1 gibt einen Überblick über den prinzipiellen Aufbau der erfindungsgemäßen Vorrichtung sowie einen Hinweis auf ihre Verwendung als Lichtkonzentrator vor einem Solarelement. Die Vorrichtung 1 besteht aus einer ersten, flächigen Prismenanordnung 3, welche aus einer Vielzahl, im wesentlichen prismatischer Profile 4 aufgebaut ist. Diese prismatischen Profile 4 sind so angeordnet, daß sie eine gemeinsame glatte Oberfläche 9 bilden, von welcher, im Querschnitt gesehen, im wesentlichen dreieckige Profile 4 hervorstehen. Der Querschnitt der Prismenanordnung 3 ist in allen zu der gezeigten Schnittebene parallelen Schnittebenen im wesentlichen gleich, d.h. daß sich jedes der prismatischen Profile 4 über die gesamte Länge der Vorrichtung 1 erstreckt. Gegenüber dieser ersten Prismenanordnung 3 befindet sich eine zweite, gleichartige Prismenanordnung 5, welche aus gleichartigen prismatischen Profilen 6 aufgebaut ist, die ebenfalls eine glatte Außenseite 10 und eine im Querschnitt aus Dreiecken bestehende Innenseite 13 aufweist. Beide Prismenanordnungen 3 und 5 sind so zusammengesetzt, daß ihre glatten Oberflächen 9 und 10 nach außen weisen und die profilierten Innenseiten 12 und 13 einander zugewandt sind. Zwischen den beiden Prismenanordnungen 3 und 5 befindet sich ein Spalt 11. In dem in Figur 1 dargestellten Fall, bei dem sich die Prismenanordnungen 3 und 5 nicht unmittelbar berühren, sind Abstandshalter 14 vorgesehen, durch die ein konstanter Abstand der beiden Prismenanordnungen 3 und 5 über deren gesamte Fläche gewährleistet ist. Diese Abstandshalter 14 können als Stifte oder Lamellen ausgebildet sein. Zusätzlich zu der erfindungsgemäßen Vorrichtung 1 ist in Figur 1 deren Anwendung als Lichtkonzentrator vor zwei Solarelementen 23 dargestellt. Das von oben, im wesentlichen senkrecht (Pfeil 17), auf die Vorrichtung 1 treffende Licht 2 wird durch diese Vorrichtung 1 in zwei Teilbündel 18 und 19 zerlegt, welche die untere Außenseite 10 der Vorrichtung 1 unter einem flachen Winkel verlassen. Hierbei tritt ein Konzentrationseffekt ein, dessen Größe vom Winkel zwischen der Einfallsrichtung 17 des Lichts 2 und den Ausfallsrichtungen 18 und 19 des die Vorrichtung verlassenden Lichts 2′ abhängt. Das so konzentrierte Licht 2′ kann in den nachgeschalteten Solarelementen 23 beispielsweise elektrischen Strom erzeugen. Diese Solarelemente 23 werden vorzugsweise durch Kühlelemente 25, welche auf der Rückseite der Solarelemente 23 angeordnet sind, gekühlt. Hierdurch wird der Wirkungsgrad der Solarelemente 23 im optimalen Bereich gehalten.

Das Funktionsprinzip der vorliegenden Erfindung wird anhand von Figur 2, welche einen Ausschnitt aus einem Querschnitt einer anderen Ausführungsform der Vorrichtung 1 darstellt, näher beschrieben. Einer ersten Prismenanordnung 3, welche im wesentlichen den gleichen Aufbau hat wie die Prismenanordnung 3 aus Figur 1, steht eine zweite gleichartige Prismenanordnung 5 gegenüber. Die relative Stellung der zweiten Prismenanordnung 5 zur ersten Prismenanordnung 3 ist jedoch gegenüber der in Figur 1 dargestellten Stellung nach oben und links verschoben, so daß die prismatischen Profile 4 und 6 an ihren Dreiecksspitzen aufeinander aufliegen und keine Abstandshalter 14 erforderlich sind.

Das auf der einen Seite 20 der Vorrichtung 1 etwa senkrecht (Pfeil 17) auf die Vorrichtung 1 auftreffende Licht 2 tritt durch die obere Außenseite 9 der ersten Prismenanordnung 3 senkrecht hindurch, ohne gebrochen zu werden. Dieses Licht gelangt sodann zur Grenzfläche 7 zwischen einem prismatischen Profil der ersten Prismenanordnung 3 und dem Luftspalt 11. Da die Grenzfläche 7 gegenüber der Außenseite 9 der ersten Prismenanordnung 3 geneigt ist, findet an dieser Grenzfläche 7 eine Brechung statt. Die Richtung dieser Brechung erfolgt wegen der geringeren optischen Dichte der Luft im Spalt 11, verglichen mit der optischen Dichte der ersten Prismenanordnung 3, vom Einfallslot weg. Das gebrochene Licht durchläuft sodann den Spalt 11 und gelangt dann zur Innenseite 13 der zweiten Prismenanordnung 5 auf eines deren prismatischer Profile 6. An dieser Grenzfläche findet entweder keine Brechung statt, wenn das Licht senkrecht auf diese Grenzfläche auftrifft, oder nur eine geringe Brechung zum Einfallslot hin, wenn das Licht unter einem leichten Winkel auf diese Grenzfläche auftrifft. Nach Durchtritt durch diese Grenzfläche 13 durchläuft das Licht eines der prismatischen Profile 6 der zweiten Prismenanordnung 5 und trifft schließlich unter einem Winkel auf deren Außenseite 10. Aufgrund dieses Winkels und des Unterschieds in der optischen Dichte zwischen der zweiten Prismenanordnung 5 und der umgebenden Luft findet hier nochmalige Brechung statt. Diese nochmalige Brechung erfolgt ebenfalls weg vom Einfallslot und damit in der gleichen Richtung wie die erste Brechung an der Grenzfläche 7. Das Licht 2′ verläßt die Vorrichtung in der durch den Pfeil 18 dargestellten Richtung, also unter einem sehr flachen Winkel zur Außenseite 10 bzw. gegenüber der Einfallsrichtung 17 um nahezu 90° gedreht. Durch die mindestens zweimalige Brechung an den Grenzflächen 7 und 8 erfolgt diese Umlenkung in zwei Schritten, wodurch sich gemäß den Fresnelschen Gleichungen die Verluste in Grenzen halten.

In analoger Weise, jedoch im umgekehrten Drehsinn, werden die Lichtstrahlen des einfallenden Lichts 2 gebrochen, welche an der Innenseite 12 der ersten Prismenanordnung 3 auf die andere Seite des Profils 4 treffen, welche im Winkel zu der eben beschriebenen Seite des Profils 4 steht. Diese Lichtstrahlen verlassen die Vorrichtung an ihrer Unterseite 21 unter dem gleichen Winkelbetrag zur Einfallsrichtung 17, jedoch mit umgekehrtem Vorzeichen, also in Ausfallsrichtung 19.

Bei breiter Bauart der Vorrichtung 1, wenn also die Prismenanordnungen 3 und 5 viele nebeneinander stehende Profile 4 und 6 enthalten, ist trotz eines flachen Ausfallswinkels der in den Richtungen 18 und 19 verlaufenden Teilstrahlen die sich ergebende Fläche zur Sammlung des gesamten konzentrierten Lichts noch zu groß. Diesem Nachteil kann mit Hilfe eines Spiegels 22, wie er in Figur 3a in Verbindung mit der Vorrichtung 1 dargestellt ist, abgeholfen werden. Der Spiegel 22 ist im Abstand von der Außenseite 10 der zweiten Prismenanordnung 5 angeordnet und reflektiert den nicht unmittelbar auf die Solarzellen 23 fallenden Teil des konzentrierten Lichts 2′, so daß auch dieser Anteil des konzentrierten Lichts schließlich den Solarzellen 23 zugeführt wird. In einer alternativen Ausführungsform, wie sie in Figur 3b dargestellt ist, ist der Spiegel 22 mit vertikal nach oben stehenden Stegen 24 versehen.

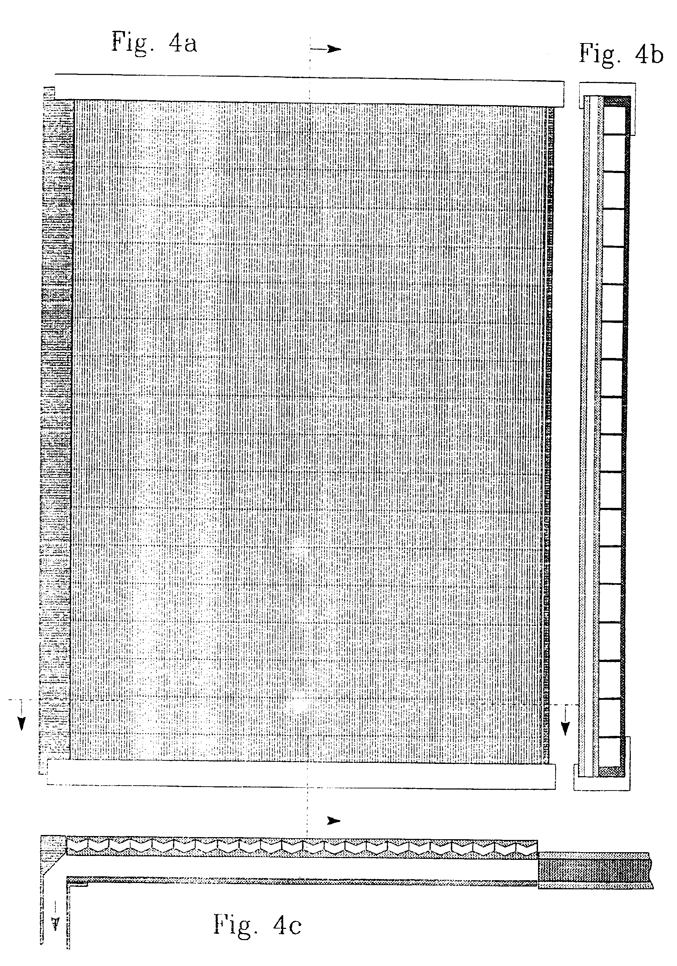

In Figur 4a ist eine Draufsicht auf eine erfindungsgemäße Vorrichtung 1 dargestellt, also eine Ansicht aus der Richtung 17 des auftreffenden Lichts 2. Die Einzelteile der Vorrichtung 1 sind in einem Rahmen 25 gehaltert. Die ebene Oberfläche 9 der ersten Prismenanordnung 3 zeigt nach oben und wird von dem einfallenden Licht beleuchtet. Die Figuren 4b und 4c zeigen einen Längs- bzw. einen Querschnitt durch die in Figur 4a dargestellte Vorrichtung. Unterhalb der aus den beiden Prismenanordnungen 3 und 5 bestehenden Vorrichtung ist ein Spiegel 22 mit Zwischenstegen 24 angeordnet. Das von der Vorrichtung 1 konzentrierte Licht wird entweder unmittelbar aus der zweiten Prismenanordnung 5 oder über diesen Spiegel 22 dem Lichtkanal 26 oder dem Lichtleiter 27 zugeführt und von dort beispielweise einem Solarelement 23 zugeleitet.

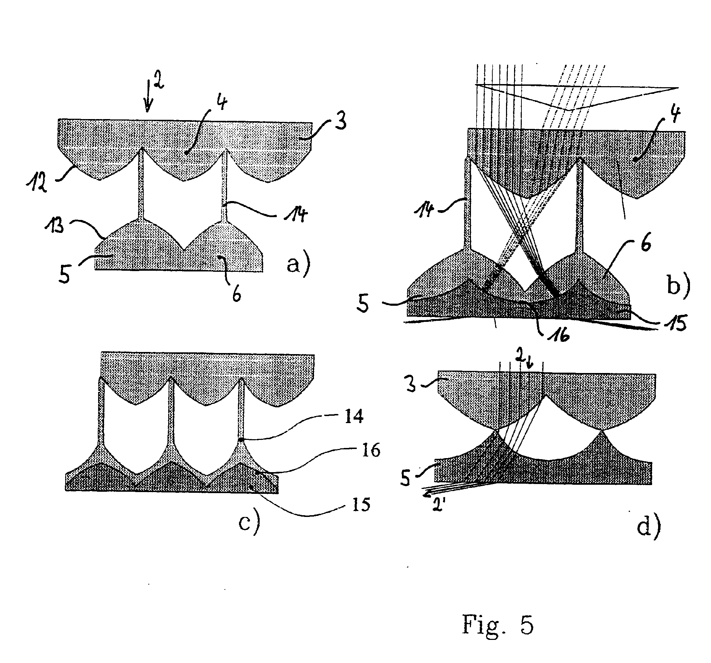

In Figur 5 sind verschiedene Ausführungsbeispiele der Gestaltung und relativen Anordnung der beiden Prismenanordnungen 3 und 5 dargestellt.

Figur 5a zeigt einen Ausschnitt aus der in den Figuren 1 und 3a dargestellten Anordnung. Die zweite Prismenanordnung 5 ist hierbei gegenüber der ersten Prismenanordnung 3 seitlich und nach unten verschoben, wodurch sich die beiden Prismenanordnungen 3 und 5 nicht mehr unmittelbar berühren. Der Abstand zwischen den beiden Prismenanordnungen wird durch stiftförmige Abstandshalter 14, welche einstückig mit der zweiten Prismenanordnung 5 verbunden sind, gehalten. Die Innenseiten 12 und 13 der Profile 4 und 6 der beiden Prismenanordnungen 3 und 5 sind nicht mehr rein prismatisch ausgebildet, sondern jede Profilfläche ist im Querschnitt konvex. Hierdurch ergibt sich der Vorteil, daß auch nicht exakt senkrecht einfallendes Licht 2 die Vorrichtung 1 in nahezu gleicher Weise verläßt, wie das genau senkrecht einfallende Licht 2. Die konvexen Grenzflächen haben also eine korrigierende Wirkung.

Eine weitere Verbesserung wird durch die in Figur 5b dargestellte Anordnung erzielt, bei der die zweite Prismenanordnung 5 eine weitere Schicht 15 aus einem Material unterschiedlicher optischer Dichte enthält und die Grenzfläche 16 zwischen der zweiten Prismenanordnung 5 und dieser weiteren Schicht 15 im Bereich jedes Profilpaars 4/6 linsenförmig ausgebildet ist. Dabei ist diese linsenförmige Ausbildung, bezogen auf die weitere Schicht 15 in Figur 5b konkav und in Figur 5c konvex dargestellt.

Die in den Figuren 5a und 5b gezeigten Ausführungsbeispiele sind insbesondere bei der Verwendung der vorliegenden Erfindung als Lichtkonzentrator vor einem Solarelement von Vorteil, wenn diese Konzentratoranordnung dem Sonnenstand nachgeführt werden muß. Durch die korrigierende Wirkung der linsenartigen Grenzflächen wird eine relativ unkritische Nachführung der Gesamtanlage zum Sonnenstand ermöglicht, z.B. mittels einer billigen, ruckweise arbeitenden Nachstellvorrichtung. Gleichzeitig werden auch durch Winddruck oder thermische Ausdehnung verursachte Verschiebungen korrigiert.

Eine weitere alternative Ausführungsform der beiden Prismenanordnungen 3 und 5 ist in Figur 5d dargestellt. Bei dieser Ausführungsform liegen beide Prismenanordnungen 3 und 5 unmittelbar aufeinander, es sind also keine Abstandshalter 14 erforderlich.

Die Erfindung wurde in der voranstehenden Beschreibung in ihrer Verwendung als Lichtkonzentrator beschrieben. Dabei kann das konzentrierte Licht beispielsweise Solarelementen 23 oder Lichtkanälen 26 bzw. Lichtleitern 27 zugeleitet werden oder aber auch anderen Vorrichtungen, bei welchen eine hohe Lichtintensität vorteilhaft ist.

Aufgrund der generellen Umkehrbarkeit des Lichtwegs läßt sich die vorab beschriebene Vorrichtung 1 jedoch auch als Lichtverteiler verwenden. In diesem Fall befinden sich anstelle der Lichtkanäle 26, Lichtleiter 27 oder Solarelemente 23 Lichtquellen und das Licht tritt aus der Vorrichtung 1 in umgekehrter Richtung des Pfeils 17 aus. Seine Intensität ist, verglichen mit der Ursprungsintensität an der Lichtquelle, um den Konzentrationsfaktor der Vorrichtung geringer. Das austretende Licht 2 kann beispielsweise zu Beleuchtungszwecken, insbesondere als Hintergrundbeleuchtung für eine Flüssigkristallanzeige, verwendet werden. Von besonderem Vorteil, speziell für diese Anwendung, ist die flache Bauweise, welche durch den starken Ablenkungswinkel der eintretenden zu den austretenden Lichtstrahlen ermöglicht wird.

In einer weiteren Ausführungsform der vorliegenden Erfindung als Lichtverteiler wird diese als Bildschirm verwendet, welcher von der Seite 20 der steil aus der Vorrichtung 1 austretenden Lichtstrahlen 2 zu betrachten ist. Das Bild wird durch Lichtquellen erzeugt, welche im Bereich der flach zu der Vorrichtung 1 verlaufenden Lichtstrahlen 2′ angeordnet sind. Diese Lichtquellen können beispielsweise einzelne oder als lineares Array angeordnete lichtemittierende Dioden sein. Zur Verteilung des Lichts von den Lichtquellen auf die Vorrichtung 1 können mechanische oder elektronische Lichtablenkvorrichtungen eingesetzt werden.

## Patentansprüche

1. Vorrichtung (1) zur Konzentration oder zur Verteilung von Licht (2, 2′) mit einer ersten, flächigen Prismenanordnung (3) aus vielen, im wesentlichen prismatischen Profilen (4) und einer zweiten, gleichartigen Prismenanordnung (5), welche in konstantem Abstand gegenüber der ersten Prismenanordnung (3) angeordnet ist, wobei jedem Profil (4) der ersten Prismenanordnung (3) ein Profil (6) der zweiten Prismenanordnung (5) zugeordnet ist, und wobei die Prismenanordnungen so ausgebildet sind, daß jeder die beiden Prismenanordnungen durchlaufende Lichtstrahl (2, 2′) an mindestens zwei Grenzflächen (7, 8) der beiden Prismenanordnungen (3, 5) im gleichen Drehsinn gebrochen wird, **dadurch gekennzeichnet,** daß jedes der prismatischen Profile beider Prismenanordnungen (3, 5) spiegelsymmetrisch zu einer senkrecht auf die flächigen Prismenanordnungen und parallel zur Längsrichtung dieses prismatischen Profils (4, 6) orientierten Ebene ausgebildet und so angeordnet ist, daß einem auf der Seite (20) der ersten Prismenanordnung im wesentlichen senkrecht hierzu verlaufenden Bündel (17) von Lichtstrahlen (2) auf der Seite (21) der zweiten Prismenanordnung zwei zueinander spiegelsymmetrische Teilbündel (18, 19) von im spitzen Winkel hierzu verlaufenden Lichtstrahlen (2′) zugeordnet sind.

2. Vorrichtung nach Anspruch 1, **dadurch gekennzeichnet**, daß die beiden Prismenanordnungen (3, 5) einstückig und plattenförmig ausgebildet sind und ihre einander abgewandten Seiten (9, 10) glatte Oberflächen bilden.

3. Vorrichtung nach einem der voranstehenden Ansprüche, **dadurch gekennzeichnet**, daß die prismatischen Profile (4, 6) im wesentlichen dreieckigen Querschnitt aufweisen, wobei ihre einander zugewandten Oberflächen (12, 13) im Querschnitt linsenförmig abgerundet sind.

4. Vorrichtung nach einem der voranstehenden Ansprüche, **dadurch gekennzeichnet**, daß die Länge der prismatischen Profile (4, 6) ihre Querschnittsabmessungen um mindestens eine Größenordnung übersteigt.

5. Vorrichtung nach einem der voranstehenden Ansprüche, **dadurch gekennzeichnet**, daß im Spalt (11) zwischen den beiden Prismenanordnungen (3, 5) stift- oder lamellenförmige Abstandshalter (14) vorhanden sind, welche mit einer der Prismenanordnungen (5) einstückig gefertigt sind.

6. Vorrichtung nach einem der voranstehenden Ansprüche, **dadurch gekennzeichnet,** daß mindestens eine der Prismenanordnungen (5) eine weitere Schicht (15) aus einem Material unterschiedlicher optischer Dichte enthält und die Grenzfläche (16) zwischen dieser Prismenanordnung (5) und der weiteren Schicht (15) im Bereich jedes Profilpaars (4, 6) linsenförmig ausgebildet ist.

7. Vorrichtung nach einem der voranstehenden Ansprüche, **dadurch gekennzeichnet**, daß an der der einen Prismenanordnung abgewandten Seite der anderen Prismenanordnung ein Spiegel (22) in konstantem Abstand zu dieser Prismenanordnung angeordnet ist.

## Claims

1. A device (1) for the concentration or distribution of light (2, 2′),
having a first plane prism arrangement (3) of numbers of essentially prismatic profiles (4) and a second like prism arrangenent (5) which is arranged at a constant distance from the first prism arrangement (3) so that one profile (6) of the second prism arrangement (5) is associated with each profile (4) of the first prism arrangement (3), and the prism arrangements are so formed that every ray (2, 2′) of light which passes through both prism arrangements is refracted in the same direction of rotation at at least two boundary faces (7, 8) of the two prism arrangements (3, 5), characterized in that
each of the prismatic profiles of both prism arrangements (3, 5) is made with mirror symmetry about a plane oriented at right angles to the plane prism arrangements and parallel with the direction longitudinal to this prismatic profile (4, 6), and so arranged that with one bundle (17) of lightrays (2) impinging upon the side (20) of the first prism arrangement essentially at right angles to it there are associated upon the side (21) of the second prism arrangement two partial bundles (18, 19) in mirror symmetry with respect to one another, of lightrays (2′) running at acute angles to the said second prism arrangement.

2. A device as in Claim 1, characterized in that
each of the two prism arrangements (3, 5) is made in one piece and in the form of a plate and their sides turned away from one another form smooth surfaces.

3. A device as in one of the preceding Claims, characterized in that
the prismatic profiles (4, 6) exhibit essentially triangular cross-sections, with their surfaces (12, 13) facing one another being ronded in cross-section in the form of lenses.

4. A device as in one of the preceding Claims, characterized in that
the length of the prismatic profiles (4, 6) exceeds their cross-sectional dimensions by at least one order of magnitude.

5. A device as in one of the preceding Claims, characterized in that
in the gap (11) between the two prism arrangements (3, 5) there are spacers (14) in the form of pins or blades which are manufactured in one piece woth one of the prism arrangements (5).

6. A device as in one of the preceding Claims, characterized in that
at least one of the prism arrangements (5) contains a further layer (15) of a material of different optical density and the boundary area (16) betwen this prism arrangement (5) and the further layer (15) is made in the form of lenses in the region of each pair (4, 6) of profiles.

7. A device as in one of the preceding Claims, characterized in that
at the side of the one prism arrangement turned away from the other prism arrangement a mirror (22) is arranged at a constant distance from this prism arrangement.

## Revendications

1. Dispositif (1) pour concentrer ou dévier la lumière (2, 2′), comprenant une première structure de prisme (3) plate faite d'une pluralité de profilés (4) pour l'essentiel prismatiques et une deuxième structure de prisme (5) identique, disposée à distance constante en regard de la première structure de prisme (3), chaque profilé (4) de la première structure (3) correspondant à un profilé (6) de la deuxième structure (5) et les structures de prisme étant constituées de manière que chaque rayon de lumière (2, 2′) traversant les deux structures de prisme (3, 5) se trouve réfracté dans le même sens de rotation à au moins deux surfaces de séparation (7, 8) des deux structures de prisme (3, 5), **caractérisé en ce que** chacun des profilés prismatiques (4, 6) des deux structures de prisme (3, 5) s'étend symétriquement par rapport à un plan perpendiculaire à la surface des structures (3, 5) et parallèle à la longueur dudit profilé prismatique (4, 6), et est disposé de manière qu'à un faisceau (17) de rayons lumineux (2) arrivant sensiblement perpendiculairement sur la face (20) de la première structure de prisme (3) correspondent sur la face (21) de la deuxième structure de prisme (5) deux faisceaux partiels (18, 19), symétriques l'un par rapport à l'autre, de rayons lumineux (2′) s'écartant à angle aigu de ladite deuxième structure (5).

2. Dispositif selon la revendication 1, **caractérisé en ce que** les deux structures de prisme (3, 5) sont d'une seule pièce et en forme de plaque et en ce que leurs faces (9, 10) éloignées l'une de l'autre forment des surfaces lisses.

3. Dispositif selon l'une des revendications précédentes, **caractérisé en ce que** les profilés prismatiques (4, 6) présentent une section transversale essentiellement triangulaire, leurs surfaces (12, 13) en regard étant en coupe arrondies en forme de lentilles.

4. Dipositif selon l'une des revendications précédentes, **caractérisé en ce que** la longueur des profilés prismatiques (4, 6) est supérieure à leurs dimensions transversales.

5. Dispositif selon l'une des revendications précédentes, **caractérisé en ce que** dans l'espace (11) entre les deux structures de prisme (3, 5) se trouvent des écarteurs (14) en forme de tiges ou de lamelles, qui sont de fabrications solidaires d'une des structures de prisme (5).

6. Dispositif selon l'une des revendications précédentes, **caractérisé en ce qu'**au moins une des structures de prisme (5) comporte une autre couche (15) en un matériau de densité optique différente et en ce que la surface de séparation (16) entre cette structure de prisme (5) et l'autre couche (15) est en forme de lentille dans le domaine de chaque paire de profilés (4, 6).

7. Dispositif selon l'une des revendications précédentes, **caractérisé en ce qu'**à l'une des faces de l'une des structures de prisme éloignée de l'autre structure de prisme se trouve disposé un miroir (22) à distance constante de cette structure de prisme.
